# EUROPÄISCHE PATENTSCHRIFT

(11) **EP 3 676 504 B1**
(45) Veröffentlichungstag und Bekanntmachung des Hinweises auf die Patenterteilung: **15.09.2021**
(21) Anmeldenummer: 18785527.5
(22) Anmeldetag: 24.09.2018
(51) Int. Cl.: F16C 29/00, F16C 29/04, F16C 32/04

(54) **VORRICHTUNG SOWIE VAKUUMKAMMER**
DEVICE AND VACUUM CHAMBER
APPAREIL ET CHAMBRE VIDE

(30) Priorität: 29.09.2017 DE 102017122754
(43) Veröffentlichungstag der Anmeldung: 08.07.2020
(73) Patentinhaber: Max-Planck-Gesellschaft zur Förderung der Wissenschaften e.V., 80539 München (DE)
(72) Erfinder: BRAUN, Wolfgang, 74321 Bietigheim-Bissingen (DE)
(74) Vertreter: Manitz Finsterwald Patent- und Rechtsanwaltspartnerschaft mbB
(86) Internationale Anmeldenummer: PCT/EP2018/075784
(87) Internationale Veröffentlichungsnummer: WO 2019/063477

(56) Entgegenhaltungen:
- DE-A1-102012 004 082
- US-A1- 2007 107 739
- US-A1- 2017 205 601

## Beschreibung

Die vorliegende Erfindung betrifft eine Vorrichtung für eine gleitreibungsfreie und schmiermittelfreie Bewegung im Vakuum, wobei die Vorrichtung eine positionsfeste Schiene und eine mittels Magnetkraft relativ dazu bewegliche Schiene umfasst. Die Erfindung betrifft ferner eine Vakuumkammer bspw. für eine Beschichtungsanlage mit einer erfindungsgemäßen Vorrichtung.

Viele Ultrahochvakuumanlagen und Vakuumanlagen benötigen Mechanismen zur Bewegung im Vakuum, sei es zur Bewegung ortsgebundener Komponenten, wie z.B. Sperrschieber oder zum Transfer von Werkstücken, z.B. in Beschichtungsanlagen. Die Mechanismen müssen sowohl Bewegungen im Vakuum ermöglichen, als auch diese von außerhalb des Vakuums nach innen oder umgekehrt übertragen.

Dabei können zumindest in Ultrahochvakuumanlagen auf Grund des erforderlichen niedrigen Restdrucks von < 10⁻⁷ Pa in der Kammer keine Schmiermittel, Kunststoffe oder andere Stoffe mit messbarem Dampfdruck verwendet werden. Zur Vermeidung einer Gleitreibung bei solchen Ultrahochvakuumanlagen wurden Mechanismen vorgeschlagen, die rollende Zylinder verwenden, die mittels Schneide-Kerbe-Eingriffe linear geführt werden (wie z.B in der DE102012004082).

Jedoch hat sich herausgestellt, dass die Fertigung dieser Rollen und der zugehörigen Führungszähne und Führungslaufbahnen mit sehr geringen Fertigungstoleranzen erfolgen muss, um einen ruhigen Laufund hohe Standzeiten (Lebensdauer) zu erzielen.

Ausgehend hiervon ist es eine Aufgabe der vorliegenden Erfindung, einen Mechanismus vorzuschlagen, der einfacher zu fertigen ist und der einen ruhigen Lauf der Vorrichtung und der Standzeiten auch im Ultrahochvakuum ermöglicht, sodass der Mechanismus reproduzierbar über längere Zeiträume verwendet werden kann.

Diese Aufgabe ist durch den Gegenstand mit den Merkmalen des Anspruchs 1 gelöst.

Eine solche Vorrichtung für eine gleitreibungsfreie und schmiermittelfreie Bewegung im Vakuum umfasst:
eine positionsfeste Schiene,
eine mittels Magnetkraft bewegliche Schiene,
zumindest zwei, maximal vier, kugelförmige Körper, bspw. Kugeln, die dazu ausgebildet sind, eine, vorzugsweise lineare, Bewegung der beweglichen Schiene relativ zur positionsfesten Schiene zu ermöglichen, wobei die kugelförmigen Körper zwischen der positionsfesten Schiene und der beweglichen Schiene angeordnet sind, sowie
eine Einheit, die dazu ausgebildet ist, die bewegliche Schiene mittels magnetischer Kopplung relativ zur positionsfesten Schiene zu bewegen und nach erfolgreicher Bewegung der beweglichen Schiene, diese ortsfest zu halten.

Dadurch, dass keine Schneide-Kerbe-Eingriffe und keine Zylinder zum Einsatz gelangen, kann die Vorrichtung sehr einfach und kostengünstig hergestellt werden. Bspw. können herkömmliche Kugeln, die als Kugeln für Kugellager verkauft werden, eingesetzt werden, sodass keine komplexen Zylinderformen mit Kerben vorgesehen werden müssen. Auch kann die Konstruktion der beweglichen Schiene und der positionsfesten Schiene bedeutend einfacher gestaltet werden, da diese keine mit den Zylindern kooperierenden Zähne aufweisen müssen.

Ferner hat sich erwiesen, dass hohe Standzeiten sich auch mit Punktkontakten, die durch die kugelförmigen Körper bereitgestellt werden, realisieren lassen. Dies steht im Gegensatz zum Stand der Technik, wo die Verwendung von Zylinderflächen vorgegeben wird, da diese als wesentlich belastbarer und verschleißfester angesehen werden, als der Punktkontakt einer Kugel. Bei Verwendung der vorliegenden Erfindung hat sich allerdings das Gegenteil gezeigt, nämlich dass mit den Punktkontakten einer Kugel bzw. eines kugelförmigen Körpers höhere Standzeiten erzielt werden, als mit den bekannten Zylinderformen.

Die kugelförmigen Körper sind sozusagen dazu ausgebildet, die bewegliche Schiene derart zu führen, dass eine lineare Bewegung der beweglichen Schiene zwischen zumindest zwei Punkten vorgegeben wird. Durch die Verwendung von Punktkontakten kann ferner der Abrieb stark reduziert werden, was zu einer Erhöhung der Standzeit führt.

Eine mittels Magnetkraft bewegliche Schiene ermöglicht einen von außen übertragbaren Antrieb dieser, wobei der Antrieb keine Schnittstelle bspw. in einer Kammerwand einer Vakuumkammer benötigt, da der Antrieb mittels einer magnetischen Kopplung erfolgen kann.

Die Vorrichtung ermöglicht eine Bewegung eines beweglichen Teils (bewegliche Schiene) entlang einer geraden oder in einer Ebene gekrümmten Bahn (positionsfeste Schiene).

Die Erfindung beschreibt somit eine Mechanik zur gleitreibungsfreien, linearen oder quasilinearen Bewegung von Bauteilen ohne Schmiermittel, insbesondere im Ultrahochvakuum (UHV). Die Bewegung wird durch rollende Kugeln ermöglicht, wobei der vorletzte Freiheitsgrad des bewegten Körpers durch eine magnetische Kopplung, bei einer Anwendung im Vakuum durch das Gehäuse von der Luftseite aus, bestimmt wird. Diese Kopplung dient gleichzeitig zur Kraft- und Bewegungsübertragung.

Die Kräfte sind so bemessen, dass nur Rollreibung auftritt und Gleitreibung vermieden wird. Durch eine Führung der Kugeln mittels Haftreibung ist die Vorrichtung gleitreibungsfrei und aufgrund der fehlenden Gleitreibung ist keine Schmierung notwendig, sodass diese auch schmiermittelfrei betrieben werden kann.

Bspw. kann die Vorrichtung für mehr als 3x10⁷ Zyklen verwendet werden, ohne dass eine Schmierung (im UHV) erfolgen muss. Somit erzielt der Mechanismus Zuverlässigkeitskennzahlen, die den Stand der Technik um mehr als einen Faktor 100 übertreffen. Der Druckanstieg bei Betätigung der Vorrichtung bei 7,5 Hz liegt bei ≤ 5x10⁻¹³ mbar (5x10⁻¹¹Pa) im Vergleich zu einer unbewegten Vorrichtung, sodass die erzielten Reinheitskennzahlen den Stand der Technik ebenfalls um mehr als einen Faktor 100 übertreffen.

Die magnetische Kopplung ist so ausgeführt, dass sie auch eine Kraft entlang der Bahn übertragen kann. Diese dient zur Verschiebung der beweglichen Schiene.

Die DE 10 2007 012 370 A1 zeigt eine Vorrichtung in der zylindrische Rollen zum Ausführen der Bewegung einer beweglichen Schiene relativ zur positionsfesten Schiene ausgebildet sind. Hierbei wird eine stabile Lagerung eines Körpers mittels mindestens drei Auflagepunkten, bzw. Auflagelinien beschrieben. Ein wesentlicher Aspekt der vorliegenden Erfindung ist es jedoch, dass die erfindungsgemäße Vorrichtung nur zwei Auflagepunkte benötigt, um dennoch eine stabile Lagerung der beweglichen Schiene zu erreichen. Dies geschieht erfindungsgemäß durch eine präzise Anordnung der Kugeln derart, dass die Positionierungen in y und z in den y-z Ebenen relativ zu einer Bewegungsachse der beweglichen Schiene durch die Kugelmittelpunkte sowie der Rotation um die x-Achse in Verbindung mit der magnetischen Kopplung geschieht. Eine solche Bewegung ist mittels eines Zylinders wie in der DE 10 2007 012 370 A1 beschrieben nicht nachvollziehbar und somit ist es auf keinste Weise offensichtlich einen Zylinder durch eine Kugel zu ersetzen, da der Fachmann davon ausgehen würde, dass die benötigte Bewegung mittels einer Kugel nicht gewährleistet wird.

Des Weiteren ist zu beachten, dass ein normales Kugellager ein gewisses Spiel zwischen den Kugeln und den beiden Ringen aufweist. Gerät nun eine Verunreinigung, z.B. ein mineralisches Staubkorn, zwischen eine Kugel und einen der Ringe, ist das kein Problem, so lange das Staubkorn kleiner ist als das Spiel. Ist das Staubkorn jedoch größer als das Spiel, steigt die Kraft, die auf das Korn und seine Auflageflächen auf Kugel und Ring wirken, sehr schnell und sehr stark mit der Korngröße an, da sowohl die Kugeln als auch die Ringe aus gehärtetem Stahl bestehen und deshalb große Kräfte zu deren Verformung aufgewendet werden müssen. Dies kann zu schnellem Verschleiß und der Zerstörung der Lager führen, insbesondere im Vakuum. Die Verunreinigung erzeugt Einkerbungen oder abgeschabtes Material, das im Vakuum an den Kugeln kleben bleibt und am Käfig reibt und damit in kurzer Zeit so viel Material abreibt, dass das Lager versagt, im Normalfall durch Verbiegen des Käfigs, welcher dann die Kugeln blockiert.

In den hier offenbarten Lagern tritt dieser Effekt nicht auf, da der Anpressdruck magnetisch ist, und im Verhältnis zum Stahl die Kraft nur sehr viel schwächer mit dem Abstand variiert. Bei der Überfahrung von Störteilchen bleibt also auch beim Übergang der Kugel die Kraft auf die normale Anpresskraft beschränkt, was normalerweise nicht zu einer Beschädigung der Kugel oder der Laufbahn durch das mineralische Staubkorn führt. Neben der Verschleißreduzierung durch die Vermeidung von Gleitreibung ist also auch der Verschleiß durch in den Mechanismus geratende kleine Fremdkörper minimal.

Schließlich haben die offenbarten Lagerungen durch die ununterbrochen wirkende magnetische Kraft kein Spiel. Im Gegensatz zum normalen Kugellager werden Kugeln und Laufbahnen immer ohne Abstand mit konstanter Kraft aneinandergedrückt. Die Lagerung ist also in dieser Richtung spielfrei und somit genauer einstellbar.

Vorzugsweise weist die bewegliche Schiene für jeden kugelförmigen Körper eine separate Fläche auf, an der der kugelförmige Körper, wie z.B. eine Kugel, anliegt. Sobald die bewegliche Schiene mittels der Einheit bewegt wird, rollen die kugelförmigen Körper entlang der positionsfesten Schiene und ermöglichen so eine lineare Bewegung der beweglichen Schiene relativ zu der positionsfesten Schiene.

Bevorzugt weist jede separate Fläche zwei Anschläge auf, wobei vorzugsweise jeder kugelförmige Körper dazu ausgebildet ist, linear zwischen den beiden Anschlägen hin- und hergeführt zu werden. Die Führung der Bewegung geschieht durch senkrecht zur Bahnebene angeordnete Flächen, vorzugsweise gekrümmte Flächen, die am beweglichen Teil und ggf. an der positionsfesten Bahn vorgesehen sind und wird durch die kugelförmigen Körper bspw. Kugeln vermittelt, wobei die Kugeln zwischen der beweglichen Schiene und der positionsfesten Schiene rollen.

Vorzugsweise ist eine Weglänge, die die linear verschiebbare bewegliche Schiene zurücklegen kann, durch einen Abstand der zumindest zwei Anschläge abzüglich des Durchmessers des kugelförmigen Körpers, gebildet. Der Bewegungsbereich der Kugeln wird durch die Anschläge eingeschränkt. Damit ist auch die Gesamtbewegung auf einen endlichen Abschnitt der Bahn eingeschränkt.

In diesem Zusammenhang ist anzumerken, dass die Anschläge an der beweglichen Schiene oder an der positionsfesten Schiene vorgesehen werden können. Bevorzugt werden diese an der beweglichen Schiene vorgesehen.

Zwischen den Anschlägen werden die Kugeln durch eine entsprechend hohe Magnetkraft so stark zwischen der beweglichen Schiene und der positionsfesten Schiene gehalten, dass keine Gleitreibung auftritt. Bei periodischer Bewegung werden die Kugeln somit durch die Endanschläge so positioniert, dass die gesamte Bewegung ohne Gleitreibung geschieht. Damit wird der Abrieb minimiert.

Gemäß einer bevorzugten Ausführungsform weist die bewegliche Schiene zumindest zwei Aussparungen auf, wobei jede Aussparung dazu ausgebildet ist, einen kugelförmigen Körper aufzunehmen. Eine Aussparung bildet einen vordefinierten Bewegungsbereich, den die bewegliche Schiene zurücklegen kann.

Die zwei Aussparungen können auf einer Seite der beweglichen Schiene oder alternativ hierzu auch auf sich gegenüberliegenden Seiten der beweglichen Schiene angeordnet sein.

Bevorzugt weist jede Aussparung die separate Fläche und die zwei Anschläge auf, wobei die zwei Anschläge vorzugsweise zumindest im Wesentlichen senkrecht bzw. senkrecht zur separaten Fläche angeordnet sind und die separate Fläche zumindest im Wesentlichen parallel zur positionsfesten Schiene angeordnet ist. Somit definieren die Aussparungen auf einfache Weise den Bewegungsbereich der beweglichen Schiene.

Nach einer besonders bevorzugten Ausführungsform umfasst die bewegliche Schiene einen Kopplungssteg, der zur magnetischen Kopplung mit der Einheit ausgebildet ist. Hierbei wird eine Bewegung der beweglichen Schiene relativ zur positionsfesten Schiene durch eine Bewegung des Kopplungsstegs induziert.

Vorzugsweise ist der Kopplungssteg zumindest benachbart einer Aussparung vorgesehen. Somit kann ein Antrieb der beweglichen Schiene benachbart des Teils der beweglichen Schiene induziert werden, der den Bewegungsbereich der beweglichen Schiene vorgibt. Besonders bevorzugt wird der Kopplungssteg demgemäß zwischen den zwei Aussparungen vorgesehen.

Vorzugsweise ist zumindest eine Führungsnut an der beweglichen Schiene, vorzugsweise an der separaten Fläche, vorgesehen, in der die kugelförmigen Körper geführt werden, um die lineare Bewegung der beweglichen Schiene vorzugeben. Insbesondere ist zudem zumindest eine Führungsnut an der positionsfesten Schiene vorgesehen, in der die kugelförmigen Körper geführt werden. Solche Führungsnuten dienen einer genaueren linearen Führung der beweglichen Schiene relativ zur Führungsschiene.

Vorzugsweise sind zwei, insbesondere genau zwei, kugelförmige Körper in einer Ebene parallel zur linearen Bewegungsrichtung der beweglichen Schiene angeordnet.

Vorzugsweise sind bei Verwendung von vier beweglichen kugelförmigen Körpern, je zwei kugelförmige Körper pro Ebene vorgesehen und die zwei Ebenen stehen zumindest im Wesentlichen senkrecht bzw. senkrecht zueinander.

In diesem Zusammenhang ist anzumerken, dass die Kugeln einerseits so groß wie möglich dimensioniert werden, um einen möglichst großen Radius der abrollenden Flächen und damit minimalen Verschleiß zu erzielen. Andererseits werden sie so klein dimensioniert, dass die Trägheitskräfte während einer beschleunigten Bewegung nicht zu einem Gleiten der Kugeln führen können.

Für schnelle Bewegungen ist es zusätzlich vorteilhaft, die Masse der beweglichen Schiene möglichst gering zu halten. Aus diesem Grund kann die bewegliche Schiene Ausschnitte, wie z.B. Nuten, Kerben oder Bohrungen bspw. im zentralen Bereich aufweisen, um die Masse der beweglichen Schiene zu reduzieren. Besonders bevorzugt ist die positionsfeste Schiene zwischen der Einheit und der beweglichen Schiene angeordnet, wobei die Einheit dazu ausgebildet ist, die bewegliche Schiene relativ zur positionsfesten Schiene zu bewegen. Somit kann ein kompakter Aufbau gewährleistet werden.

Vorzugsweise umfasst die bewegliche Schiene und/oder der Kopplungssteg ein magnetisches Material, vorzugsweise ein nicht ferromagnetisches Material. D.h. es sind keine Permanentmagnete im Vakuum vorgesehen, somit kann die Vorrichtung auch im UHV Bereich betrieben werden. In diesem Zusammenhang ist anzumerken, dass die bewegliche Schiene bevorzugt einstückig ausgebildet ist, sodass bis auf die bewegliche Schiene, die Kugeln und ggf. ein Haltelement, das dazu ausgebildet ist die bewegliche Schiene an einer Stelle, bspw. einer Vakuumkammer, zu halten, die Vorrichtung aus relativ wenig Teilen besteht. Somit kann eine minimale Oberfläche in das Vakuum eingebracht werden, wobei die Reinheit in der Kammer relativ wenig beeinträchtigt wird.

Bevorzugt umfasst die Einheit Magnete, die dazu ausgebildet sind, die bewegliche Schiene, vorzugsweise linear, zu bewegen und ortsfest zu halten.

Vorzugsweise weist die Einheit ein magnetisches Material und zumindest ein Paar an gegensinnig gepolten Magneten auf, die die magnetische Kopplung zur beweglichen Schiene bereitstellen. Durch eine solche Anordnung werden ringförmige Feldlinien erzeugt, die neben der magnetischen Kopplung zwischen der Einheit und der beweglichen Schiene ein besonders geringes magnetisches Streufeld ermöglichen.

Besonders bevorzugt weist die Einheit zwei Rollen auf, mittels derer die Einheit relativ zur positionsfesten Schiene verschoben werden kann. Rollen ermöglichen eine relativ reibungsarme Bewegung der Einheit relativ zur positionsfesten Schiene.

Optional kann auf der entgegengesetzten (Ober-)Seite der Einheit eine zweite Einheit mit schwächeren Magneten angeordnet werden, die mechanisch in Bewegungsrichtung starr mit der ersten Einheit gekoppelt wird. Diese greift magnetisch an zwei zusätzlichen Zapfen auf der Oberseite der beweglichen Schiene an und erhöht die übertragbare Kraft. Zusätzlich stabilisiert sie die bewegliche Schiene in Bezug auf Drehmomente um die Achse der Bewegungsrichtung. Zusätzlich vermindert sie den Anpressdruck auf die Kugeln, was zu weiter verringertem Verschleiß führt

Optional kann die Einheit zweiteilig 'zweistöckig' ausgeführt werden, quasi spiegelbildlich zur Anordnung im Vakuum. Dabei bewegt sich die dem Gehäuse nähere Ebene mit der halben Geschwindigkeit, d.h. wie die Kugeln im Vakuum. Die dem Gehäuse fernere Ebene bewegt sich wie die bewegliche Schiene. Auf dieser ferneren Ebene sind die Koppelmagnete zur beweglichen Schiene montiert. Werden (magnetische) Stahlkugeln verwendet, so können Koppelmagnete an der näheren Ebene der Einheit an den Positionen der Kugeln im Vakuum angeordnet werden, die direkt auf die Kugeln wirken. Dies führt zu einer stärkeren Führung der Kugeln in Bewegungsrichtung und damit zu weiter verringerter Gleitreibung, bzw. höheren möglichen Beschleunigungen bevor verstärkter Verschleiß durch Gleitreibung einsetzt.

Optional ist die Einheit in einer Führung angeordnet, die einen Bewegungsbereich der Einheit vorgibt. Mittels der Führung kann von außen sichergestellt werden, dass die bewegliche Schiene in einem vordefinierten Bewegungsbereich bewegt wird.

Vorzugsweise ist die bewegliche Schiene als Schubstange ausgebildet, um Objekte, die an der Schubstange angeordnet sind, insbesondere linear, zu verschieben. Bspw. kann die bewegliche Schiene Blenden, Targets, Werkstücke oder Ähnliches in einer Vakuumkammer zwischen mehreren Punkten verschieben, sodass diese bei Gebrauch ein und ausfahrbar sind.

Vorteilhafterweise ist die positionsfeste Schiene durch zumindest eine Kammerwand einer Vakuumkammer gebildet. Somit wird eine Übertragung einer Bewegung im Vakuum durch Magnetkraft und zwei rollende kugelförmige Körper zwischen einer festen Schiene, die aus der Kammerwand besteht, und der beweglichen Schiene ermöglicht.

Bei Verwendung von bspw. Stahlteilen auf der Vakuumseite kann die Vakuumkammer extrem hoch ausgeheizt werden, bspw. bis zu 400°C. Bei gleichzeitiger entsprechender Auslegung der Materialien auf der Luftseite sind hier ebenfalls hohe Betriebstemperaturen von > 300°C möglich. Die Betriebstemperaturen der Vorrichtung sind lediglich durch die Hochtemperatureigenschaften der Materialien bspw. der verwendeten Stahllegierungen der Vorrichtung begrenzt.

Gemäß einem weiteren Aspekt betrifft die vorliegende Erfindung eine Vakuumkammer bspw. einer Beschichtungsanlage mit einer Vorrichtung wie sie hierin beschrieben ist, sowie einer Schubstange, die an der beweglichen Schiene angeordnet ist und bspw. eine Blende zwischen zwei Punkten im Raum verschieben kann, wobei die Vorrichtung dazu ausgebildet ist, die Schubstange bzw. Blende, vorzugsweise linear, in der Vakuumkammer zu verfahren.

Die Vorteile, die im Zusammenhang mit der erfindungsgemäßen Vorrichtung erläutert wurden, gelten sinngemäß für die erfindungsgemäße Vakuumkammer.

Die Erfindung wird nachfolgend rein beispielhaft unter Bezugnahme auf die Zeichnungen näher erläutert. Es zeigen:
- Fig. 1: eine schematische Abbildung einer erfindungsgemäßen Vorrichtung in einer Seitenansicht mit einem Längsschnitt durch das Gehäuse;
- Fig. 2: eine isometrische Ansicht der Vorrichtung der Fig. 1;
- Fig. 3: einen Schnitt quer zur Längsachse in Blickrichtung nach hinten entlang der Schnittlinie A-A durch die Zeichnung der Fig. 2;
- Fig. 4: eine weitere isometrische Ansicht der Vorrichtung der Fig. 1 mit einer Magnetwagenführung und einem Sicherungsclip;
- Fig. 5: eine schematische Abbildung einer weiteren erfindungsgemäßen Vorrichtung;
- Fig. 6: eine schematische Abbildung einer weiteren erfindungsgemäßen Vorrichtung;
- Fig. 7: eine schematische Abbildung einer weiteren erfindungsgemäßen Vorrichtung;
- Fig. 8: eine schematische Abbildung einer weiteren erfindungsgemäßen Vorrichtung; und
- Fig. 9: eine schematische Abbildung einer weiteren erfindungsgemäßen Vorrichtung.

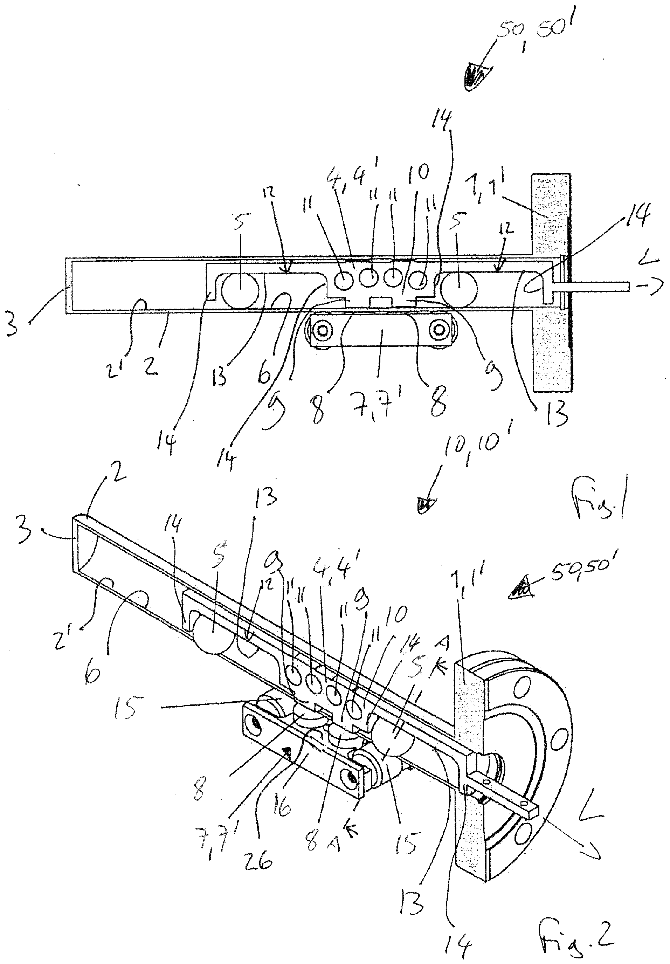

Die Fig. 1 zeigt eine schematische Abbildung einer erfindungsgemäßen Vorrichtung 50 am Beispiel eines Shuttermechanismus 50' in einer Seitenansicht mit einem Längsschnitt durch ein Gehäuse 1. Das Gehäuse 1 ist in dieser beispielhaften Ausführung aus einem Ultrahochvakuumflansch 1' (Edelstahl Größe DN CF40) mit einem angeschweißten, nichtmagnetischen Edelstahlrohr 2 (Größe 18x1) und angeschweißtem Abschlussdeckel 3 gefertigt.

In dem Gehäuse 1 sind eine als Schubstange 4 ausgebildete bewegliche Schiene 4' sowie zwei Stahlkugeln 5 angeordnet. Die Schubstange 4 besteht aus magnetischem, nicht ferromagnetischem Material, in diesem speziellen Fall aus Edelstahl 1.4112. Die damit zu erreichende Haltekraft ist ausreichend, um eine ordnungsgemäße Funktion der Schubstange 4 zu erzielen und vermeidet ferner die Verwendung von Materialen wie NdFeB oder CoSm, die zwar als Permanentmagnete ein deutlich stärkeres Magnetfeld aufweisen, aber nicht wirklich ultrahochvakuumkompatibel sind.

Die Schubstange 4 liegt lediglich an zwei Punkten auf den Stahlkugeln 5 auf. Die Stahlkugeln 5 rollen entlang der unteren Innenfläche 6 des Edelstahlrohrs 2 und ermöglichen so eine lineare Bewegung der Schubstange 4. Das Edelstahlrohr 2 bildet eine positionsfeste Schiene 2' relativ zu der die bewegliche Schiene 4' bewegbar ist.

Die Vorrichtung 50, 50' umfasst die Schubstange 4, die positionsfeste Schiene 2', eine Einheit 7, die einen Magnetwagen 7' aufweist und zwei Kugeln 5, die zwischen der positionsfesten Schiene 2' und der beweglichen Schiene 4' angeordnet sind. Die bewegliche Schiene 4' wird mittels der Einheit 7 gleichzeitig relativ zur positionsfesten Schiene 2' bewegt und relativ zu dieser mittels einer magnetischen Kopplung gehalten. Hierzu weist die Einheit 7 den Magnetwagen 7' auf, der mit zwei Rundmagneten 8 ausgestattet ist.

In dem vorliegenden Beispiel weisen die Rundmagnete 8 einen Durchmesser von 10 mm bei einer Höhe von 5 mm auf. Generell können die Rundmagnete einen Durchmesser im Bereich von 5 bis 20 mm und eine Höhe von 3 bis 10 mm aufweisen. Die Rundmagnete 8 sind aus NdFeB hergestellt.

Die Rundmagnete 8 koppeln magnetisch mit Zapfen 9, die an der beweglichen Schiene 4' vorgesehen sind. Die Zapfen 9 sind an einem Kopplungssteg 10 der beweglichen Schiene 4' angeordnet, indem diese von einer unteren Seite des Kopplungsstegs 10 in Richtung der Innenfläche 6 absteht. Eine Bewegung der beweglichen Schiene 4' relativ zur positionsfesten Schiene 2' wird durch eine Bewegung der Einheit 7' und somit des Kopplungsstegs 10 induziert.

Um ein Gewicht der beweglichen Schiene 4' zu reduzieren weist der Kopplungssteg 10 ferner vier Bohrungen 11 auf. In diesem Beispiel bilden die Seitenwände des Kopplungsstegs 10 auch die Anschläge 14. Die Aussparungen 12 sind an einer Seite der beweglichen Schiene 4 angeordnet, nämlich an der gleichen Seite der beweglichen Schiene 4' wie die Zapfen 9.

Der Kopplungssteg 10 ist zwischen zwei Aussparungen 12 angeordnet. Jede Aussparung 12 weist eine separate Fläche 13 auf, an der die jeweilige Kugel 5 anliegt und zwei Anschläge 14, die senkrecht zu der separaten Fläche 13 angeordnet sind. Die jeweilige Kugel 5 kann linear zwischen den beiden Anschlägen 14 einer Aussparung 12 hin- und hergeführt werden. Der Abstand zwischen den zwei Anschlägen 14 definiert eine Weglänge, die die linear verschiebbare bewegliche Schiene 4' zurücklegen kann. Die separate Fläche 13 ist parallel zu der positionsfesten Schiene 2' angeordnet. Ein Übergang zwischen den Anschlägen 14 und der separaten Fläche ist als gekrümmte Fläche ausgebildet um Ermüdungsbrüchen an dieser Stelle vorzubeugen, könnte auch als Rechteck oder Ähnlichem ausgebildet sein. Der Krümmungsradius des Übergangs ist kleiner als ein Radius der jeweiligen Kugel 5, um sicherzustellen, dass die Kugeln 5 nicht an diesen Übergängen anschlägt, aber erst an den Anschlägen 14.

Ein Zentralkörper 26 (siehe Fig. 2) des Magnetwagens 7' ist ebenfalls aus magnetischem Material gefertigt, insbesondere aus Edelstahl 1.4112. Die Rundmagnete 8 werden gegensinnig gepolt auf den Magnetwagen 7' gelegt, an dem sich die Rundmagnete 8 aufgrund ihres Magnetismus selbst befestigen. Eine weitere Halterung ist somit nicht notwendig.

Durch die gegensinnige Polung (ein Magnet 8 Nordpol oben, ein Magnet 8 Nordpol unten) schließen sich die magnetischen Feldlinien zu einem Ring, der bis auf die kleinen Spalten luft- und vakuumseitig in hochpermeablem Material verläuft und somit minimale Streufelder erzeugt. Es ist somit vorteilhaft, eine geradzahlige Anzahl von paarweise gegensinnig orientierten Koppelmagneten 8 zu verwenden.

Mittels der Feldlinien werden die zwei Zapfen 9 und somit die bewegliche Schiene 4' relativ zu den Magneten 8 ortsfest gehalten. Bei Bewegung der Einheit 7 relativ zum Rohr 2, führen die Zapfen 9 die Bewegung der Einheit aufgrund der magnetischen Kopplung mit aus, so dass die bewegliche Schiene 4' in der gleichen Richtung geführt wird, wie die Einheit 7, nämlich in Richtung der Längsrichtung L.

Die Magnetstärke der Magnete 8 ist derart stark ausgewählt das die bewegliche Schiene 4' in Richtung der Einheit 7 und somit in Richtung der Kugeln 5 gezogen wird, sodass die Kugeln 5 sozusagen zwischen der beweglichen Schiene 4' und der positionsfesten Schiene 2' eingeklemmt werden. Jedoch darf diese Klemmung nicht so stark sein, dass die Kugeln 5 nicht mehr elastisch auf den beiden Schienen 4', 2' abrollen können, sondern so stark eingedrückt werden, dass Kugeln und Schienen sich stark gegenseitig plastisch verformen und durch den resultierenden Materialabtrag (,fressen') schnell gegenseitig zerstören. Die Einstellung dieses Klemmdrucks ist die wesentliche Optimierungstätigkeit zur Erzielung einerseits hoher Bewegungsfrequenzen bei andererseits minimalem Verschleiß.

Der Abstand der Symmetrieachsen der Magnete 8 wird vorteilhafterweise anders, vorteilhafterweise etwas kleiner gewählt als der Abstand der Mittelebenen der Zapfen 9. Dies ergibt eine härtere Kopplung in Bewegungsrichtung, d.h. einen steileren Anstieg der Rückstellkraft bei einer relativen Auslenkung von beweglicher Schiene 4' und Einheit 7 zueinander. Abweichungen der Breite der Zapfen 9 in Bewegungsrichtung vom Durchmesser der Magnete 8, sowie generell voneinander abweichende Formen von Zapfen 9 und Magneten 8 können denselben Effekt haben und zur weiteren Optimierung eingesetzt werden.

Die Fig. 2 zeigt eine isometrische Ansicht der Vorrichtung 50 der Fig. 1. In dieser sind zwei Kunststoffrollen 15 am Magnetwagen 7' vorgesehen, sodass der Magnetwagen 7' außen am Edelstahlrohr 2 rollen kann.

In diesem Zusammenhang könnten auch Kugellager verwendet werden, es hat sich jedoch gezeigt, dass Rollen aus Polyoxymethylen (POM) eine hervorragende Verschleißfestigkeit haben (mit Schmierung typischerweise mehr als 30 Millionen Zyklen) und im Betrieb wesentlich leiser sind.

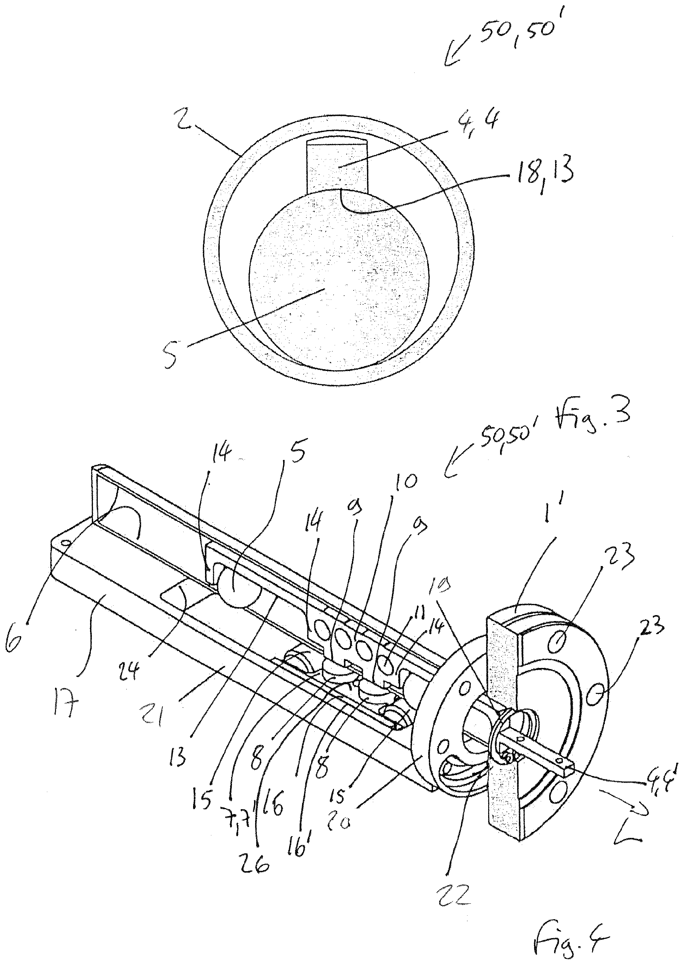

Der Magnetwagen 7' weist ferner zwei Gleitplatten 16 auf sich gegenüberliegenden Seiten auf, wovon eine in der gezeigten Figur nicht sichtbar ist. Die Gleitplatten 16 sind ebenfalls aus POM gefertigt. Die Gleitplatten 16 stützen den Magnetwagen 7' an der Magnetwagenführung 17 (siehe Fig. 4) ab, sodass sich der Magnetwagen 7' entlang einer geraden Linie parallel zur Längsachse L des Rohrs bewegt.

Die Fig. 3 zeigt einen Schnitt quer zur Längsachse L in Blickrichtung nach hinten entlang der Schnittlinie A-A durch die Zeichnung der Fig. 2. Die auf den Kugeln 5 rollenden Flächen 13 der Schubstange 4 sind gekrümmt als Führungsnut 18 gefertigt. Die Führungsnut 18 hat einen Radius, der in etwa 4% größer als der Radius der Kugeln 5 ist. Dieses Radiusverhältnis wird in den meisten Kugellagern verwendet und hat sich auch hier bewährt. Der Unterschied der Radien ist zu klein, um in den Abbildungen sichtbar zu sein.

Die seitliche Führung der Schubstange 4 geschieht somit durch die äußere Positionierung der Magnete, die neben der Auflagekraft von der beweglichen Schiene 4' auf die Kugeln und von den Kugeln auf die positionsfeste Schiene 2' und der Bewegungsübertragung auch eine seitliche Rückstellkraft ausüben, sowie durch die innere Krümmung der auf den Kugeln 5 aufliegenden beweglichen Schienen 4' und die innere Krümmung des Rohrs 2, in dem die Kugeln 5 abrollen. Die Krümmung des Rohrs 2 übernimmt somit die Funktion der unteren Führungsschiene mit, die im Stand der Technik noch durch ein separates Bauteil realisiert wird, und bildet dabei eine Führungsnut, die an der positionsfesten Schiene 2' vorgesehen ist.

Die positionsfeste Schiene 2' ist zwischen der Einheit 7, die dazu ausgebildet ist, die bewegliche Schiene 4' relativ zur positionsfesten Schiene 2' zu bewegen, und der beweglichen Schiene 4' angeordnet.

Die Fig. 4 zeigt eine weitere isometrische Ansicht der Vorrichtung der Fig. 1 mit der Magnetwagenführung 17. Die Magnetwagenführung 17 ist typischerweise aus eloxiertem Aluminium gefertigt. Sie kann mittels zweier Rändelschrauben (nicht gezeigt) zusammen mit dem Magnetwagen 7' ohne Werkzeug abgenommen werden, wenn die Vakuumkammer 1 mit angeflanschtem Shuttermechanismus 50' ausgeheizt werden soll.

Die Magnetwagenführung 17 umfasst einen Führungsrahmen 21 und einen senkrecht dazu angeordneten Haltering 20. Der Führungsrahmen 21 umfasst eine Öffnung 24, in der die Einheit 7 mit dem Magnetwagen 7' geführt wird. Die Öffnung 24 ist nur unwesentlich (ca. 0,2 mm) breiter wie der Magnetwagen 7', d.h. der Abstand zwischen den Außenflächen 16' der Gleitplatten 16, sodass keine wesentlichen seitlichen Verschiebungen möglich sind, und hierbei mögliche Abweichungen von einer linearen Bewegung herbeigeführt werden. Die Länge der Öffnung 24 definiert eine Weglänge, die der Magnetwagen 7' zurücklegen kann. Die Länge der Öffnung entspricht somit auch der Weglänge, die die bewegliche Schiene 4' in dem Rohr 2 zurücklegen kann. Da die magnetische Kopplung nicht starr ist, wird die Länge der Öffnung 24 vorteilhafterweise etwas kleiner gewählt als die Weglänge der bewegliche Schiene 4', bevor die Kugeln 5 die Anschläge 14 berühren. Damit ist ein Überschwingen der beweglichen Schiene 4' beim Erreichen der Endpositionen möglich ohne dass eine Kugel 5 einen Anschlag 14 berührt.

Eine gebogene Nut 22 für die Verbindungsschrauben (nicht gezeigt) zwischen Haltering 20 und Führungsrahmen 21 erlaubt eine stufenlose Einstellung der azimutalen Position des Magnetwagens 7'. Die gebogene Nut 22 ist so ausgeführt, dass sie im Winkel mehr als einen Lochabstand auf dem Teilkreis der Befestigungslöcher 23 des Flansches 1' (hier 60°) umfasst, sodass das Gehäuse in praktisch beliebiger Orientierung an die Vakuumkammer geschraubt werden kann, der Shuttermechanismus 10' aber immer in der gezeigten vertikalen Anordnung mit der Schubstange 4 senkrecht über den Kugeln betrieben werden kann. Dies ist vorteilhaft, um eine gleichmäßige Beanspruchung der mechanischen Teile und damit die maximale Lebensdauer zu gewährleisten.

Es hat sich auch gezeigt, dass die Lebensdauer weiter erhöht werden kann, wenn nach einer längeren Betriebszeit die azimutale Position des Magnetwagens um einige Grad verschoben wird, womit sich die Abrollbahn auf der festen Schiene 2' auf eine vorher unbeanspruchte Oberfläche verschiebt.

Die Fig. 4 zeigt ferner einen Sicherungsclip 19, der ein Herausfallen der beweglichen Schiene 4' und der Kugeln 5 bei abgekoppelten Magnetwagen 17 aus dem Rohr 2 verhindert, insbesondere wenn die Vorrichtung 50 senkrecht an eine Vakuumkammer (nicht gezeigt) gekoppelt ist. Der Sicherungsclip 19 wird in einer Nut an der Innenfläche 6 des Rohrs 2 befestigt. Der Sicherungsclip 19 kann mit üblichen dafür vorgesehenen Zangen eingesetzt und wieder entfernt werden.

Somit sind für die Montage und Demontage der Vorrichtung 50 keine weiteren Werkzeuge notwendig. Insbesondere sind keine Schraub-, Schweiß-, oder Nietverbindungen notwendig, was versehentliche Verschmutzungen des Ultrahochvakuums durch in Spalten festsitzende Verschmutzungen oder virtuelle Lecks vermeidet. Mit Ausnahme des Gehäuses 1 sind alle mit dem Vakuum in Berührung kommenden Teile aus einem Stück gefertigt, um diese Probleme zu vermeiden.

Das Gehäuse 1 bzw. das Rohr 2 welches eine Kammerwand einer Vakuumkammer bildet, dient als positionsfeste Schiene 2', damit ist die Vorrichtung 50 einfacher, robuster und preiswerter in ihrer Herstellung.

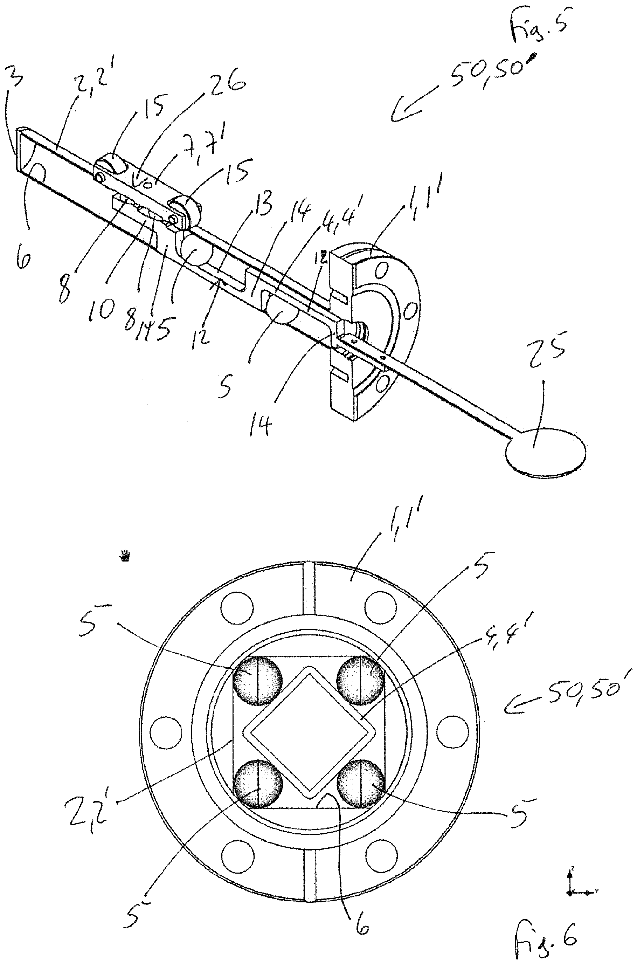

Die Fig. 5 zeigt eine schematische Abbildung einer weiteren erfindungsgemäßen Vorrichtung 50. In dieser Vorrichtung 50 sind die Kugeln 5 auf sich gegenüberliegenden Seiten der beweglichen Schiene 4' angeordnet. Diese Variante lässt sich etwas kürzer bauen, da der Magnetwagen 7' nur auf einer Seite den entsprechenden Abstand zur Kugel 5 einhalten muss, damit diese nicht so stark angezogen wird, dass sie sich nicht mehr bewegt. Bei dieser Variante ist im Gegensatz zu der in den Fig. 1 bis 4 gezeigten Variante der Kopplungssteg 10 benachbart nur einer Aussparung 12 vorgesehen. Der mittlere Anschlag 14 bildet in diesem Fall für beide Aussparungen 12 einen Anschlag

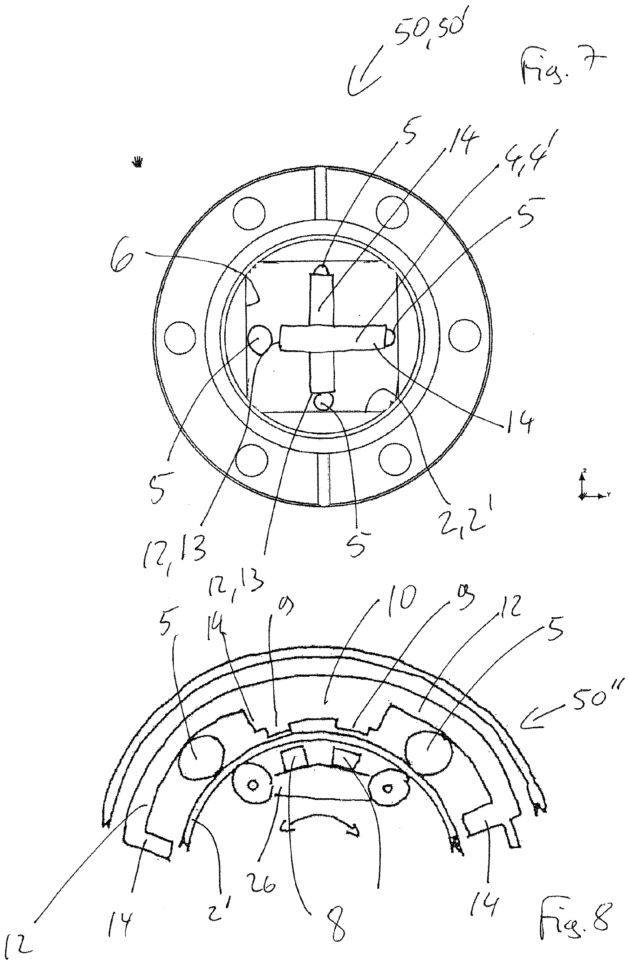

Es hat sich jedoch gezeigt, dass die seitliche (senkrecht zur Bildebene in Fig. 5) Gleichgewichtslage in dieser Variante instabil ist. Diese lässt sich durch einen zweiten Magnetwagen (nicht gezeigt) auf der Unterseite im Bereich unterhalb der hinteren Kugel 5 kompensieren. Es kommt jedoch hinzu, dass sich Maßtoleranzen in der Form der Schubstange 4, der Größe der Kugeln 5 und dem Innendurchmesser des Rohrs 2 aufsummieren, sodass eine unnötig präzise Fertigung dieser Variante notwendig ist. Dies wirkt sich auch auf die Zuverlässigkeit aus. Die Variante mit gegenüberliegenden Kugeln 5 lässt sich aber auf eine in zwei Ebenen zueinander senkrechte Variante erweitern (siehe Fig. 7), die für große Hübe deutliche Vorteile aufweist.

Bei der in der Fig. 5 gezeigten Variante, ist eine Blende 25 an der Schubstange 4 vorgesehen. Eine solche Blende 25 kann beispielsweise in einer Beschichtungsanlage, wie z.B. einer Moleküllagenabscheidungsanlage, verwendet werden.

Die bewegliche Schiene 4' ist als Schubstange 4 ausgebildet, um Objekte, wie die Blende 25, die an der Schubstange 4 angeordnet sind, linear hin und her zu verschieben.

Fig. 6 zeigt eine schematische Abbildung einer weiteren erfindungsgemäßen Vorrichtung. Bei den in den Figuren 1 bis 5 gezeigten Ausführungsformen sind jeweils genau zwei Kugeln 5 in einer Ebene parallel zur linearen Bewegungsrichtung der beweglichen Schiene 4' angeordnet.

Bei der in Fig. 6, wie in der Fig. 7, gezeigten Variante sind jeweils zwei Paare von Kugeln 5 in einem rechteckigen Rohr 2 vorgesehen. In dem Beispiel der Fig. 6 ist eine rechteckige positionsfeste Schiene 2' als Rohr 2 vorgesehen. Die bewegliche Schiene 4' ist um 45° gedreht relativ zur positionsfesten Schiene 2'. Die vier Kugeln 5 sind in den Räumen zwischen den flachen Seiten der beweglichen Schiene 4' und den Ecken der positionsfesten Schiene 2' angeordnet. Somit sind die vier Kugeln in zwei Ebenen vorgesehen, wobei die zwei Ebenen senkrecht zueinander und parallel zur Bewegungsrichtung angeordnet sind.

Fig. 7 zeigt eine schematische Abbildung einer weiteren erfindungsgemäßen Vorrichtung. Bei dieser Ausführungsform ist die in Fig. 5 gezeigte Variante mit gegenüberliegenden Kugeln 5 auf eine Variante erweitert, bei der die bewegliche Schiene 4' quasi durch zwei senkrecht zueinander geformte bewegliche Schienen 4' wie diese in Fig. 5 gezeigt ist, geformt wird.

Somit sind vier Aussparungen 12 an der beweglichen Schiene 4' vorgesehen, die kreuzförmig an sich gegenüberliegenden Seiten der beweglichen Schiene 4' angeordnet sind, wobei zwei Aussparungen 12 in einem vorderen Bereich der beweglichen Schiene 4' im rechten Winkel zueinander derart angeordnet sind, das sich ihre separate Fläche 13 gegenüber der Innenfläche 6 des quadratischen Rohrs 2 befindet. Im hinteren Bereich der beweglichen Schiene 4' sind die zwei Aussparungen 12 ebenfalls derart im rechten Winkel zueinander angeordnet, dass sich ihre separate Fläche 13 gegenüber der Innenfläche 6 des quadratischen Rohrs 2 befindet. Ein mittig angeordneter kreuzförmiger Steg (nicht gezeigt), bildet somit einen Anschlag 14 für alle vier Aussparungen 12.

Die vier Kugeln 5 sind jeweils mittig an den flachen Seiten der positionsfesten Schiene 2' angeordnet und lagern so die bewegliche Schiene 4'. Bei dieser Variante sind je zwei Kugeln pro Ebene vorgesehen, die senkrecht zueinander stehen.

Hierzu ist in jeder Ebene die bewegliche Schiene 4' ähnlich der in der Fig. 5 gezeigten beweglichen Schiene 4' ausgebildet, d.h. zwei Kugeln 5 der Paare von Kugeln sind in einem vorderen Bereich der beweglichen Schiene 4' angeordnet und die anderen zwei Kugeln 5 des jeweiligen Paares sind in einem hinteren Bereich der beweglichen Schiene 4' angeordnet.

Fig. 8 zeigt eine schematische Abbildung einer weiteren erfindungsgemäßen Vorrichtung 50". Bei dieser Variante verläuft die resultierende Bewegung nicht linear, sondern entlang eines Kreisbogens. Solche Anordnungen sind sowohl mit konvexer als auch konkaver Krümmung denkbar, selbst Bewegungen die nicht auf einer Kreisbahn erfolgen sind möglich, so lange zwischen den Koppelmagneten 8 und der Schubstange 4 im genutzten Bereich ein genügend kleiner Abstand bestehen bleibt, um die Funktionsfähigkeit zu gewährleisten.

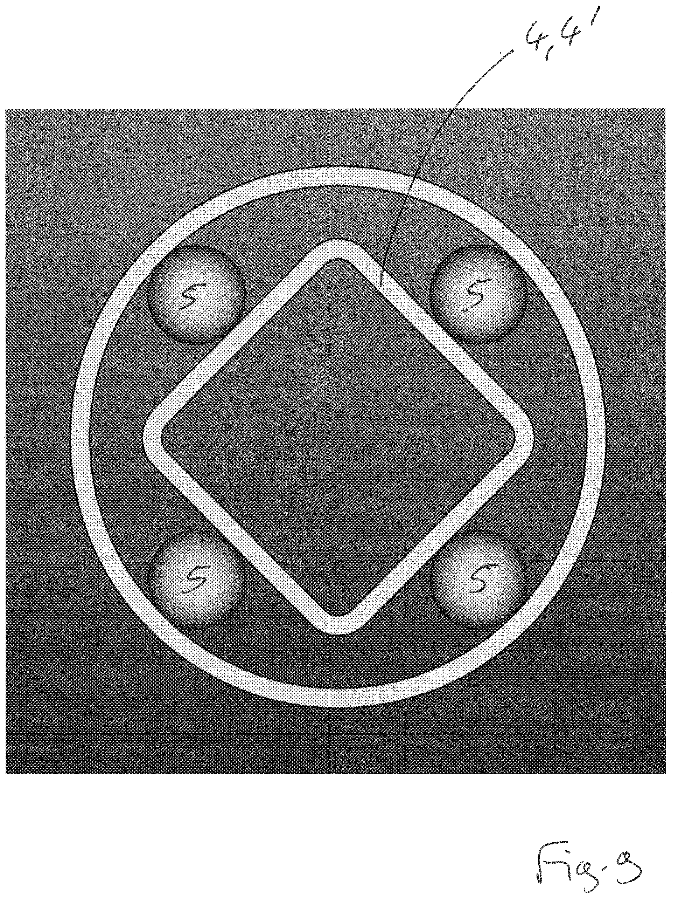

Fig. 9 zeigt eine schematische Abbildung einer weiteren erfindungsgemäßen Vorrichtung 50' ähnlich der Fig. 6. Im Unterschied zu der Fig. 6 werden die Kugeln 5 in einem zylindrischen Rohr 2 anstelle einem rechteckigen Rohr 2 als positionsfeste Schiene 2' geführt. Jeweils zwei Paare von Kugeln 5 sind auf gegenüberliegenden Seiten der beweglichen Schiene 4' angeordnet. Die vier Kugeln 5 sind ebenfalls in zwei Ebenen vorgesehen, wobei die zwei Ebenen senkrecht zueinander und parallel zur Bewegungsrichtung angeordnet sind. Durch die Anordnung in einem zylindrischen Außenrohr 2, liegen die Kugeln 5 jeweils jedoch nur mittels einem Auflagepunkt an der positionsfesten Schiene 2' an. In Fig. 6 liegen die Kugeln jeweils mit zwei Auflagepunkten an der positionsfesten Schiene 2' an. Durch die Anordnung in Fig. 9 ergibt sich, eine Rollbewegung ohne die zusätzliche Drehung um die Auflagepunkte ähnlich der Rollbewegung der Ausführung in Fig. 7 bei einer Reduzierung der Reibung und Verschleiß.

Zusätzlich lässt sich die bewegliche Schiene 4, bei entsprechender Mitdrehung der zur Stabilisierung notwendigen Kräfte, in jede beliebige gedrehte Position um die senkrecht zur Zeichenebene stehende Achse drehen.

Je nach Variante kann die positionsfeste Schiene 2' somit einen runden, quadratischen oder rechteckigen Querschnitt senkrecht zu einer Bewegungsachse der bewegliche Schiene 4' aufweisen.

Eine nicht gezeigte Vakuumkammer für eine Beschichtungsanlage, die mit einer vorstehend beschriebenen Vorrichtung 50, 50', 50" verwendet werden kann, umfasst zumindest eine Vakuumpumpe, mittels derer ein Vakuum von ≤ 0,1 Pa, bevorzugt ≤ 5x10⁻³ Pa ≤ 5x10⁻⁷ Pa in der Kammer hergestellt werden kann, sowie einen Flansch an den das Gehäuse 1 der Vorrichtung 50, 50', 50" angeschlossen werden kann, um die bewegliche Schiene 4' der Schubstange 4 zu verfahren, um bspw. die Blende 25 in der Vakuumkammer zu verfahren.

In diesem Zusammenhang ist anzumerken, dass die Kugeln 5 einen Kugeldurchmesser von 0, 5 mm bis hinzu 1 m haben können, jedoch werden bevorzugt Kugeln 5 mit einem Kugeldurchmesser im Bereich von 3 mm bis hinzu 15 mm verwendet. Bei den hier gezeigten Kugeln 5 werden Durchmesser von 8 mm verwendet.

Die hier gezeigten Kopplungsmagnete 8 weisen eine Magnetfeldstärke von 0,5 T auf. In Abhängigkeit der Materialen des Rohrs 2, sowie der Wandstärke des Rohrs 2 kann eine Magnetfeldstärke im Bereich von 0,2 T bis 1 T verwendet werden.

Bevorzugt werden Kugeln 5 aus Edelstahl in der Vorrichtung 50, 50', 50" verwendet, es können jedoch auch Kugeln 5 aus Silizium bzw. Silizium Verbindungen oder keramische Kugeln bspw. aus Zirconiumdioxid als Kugeln 5 verwendet werden.

### Bezugszeichenliste:

- 1, 1': Gehäuse, Flansch
- 2, 2': Edelstahlrohr, positionsfeste Schiene
- 3: Abschlussdeckel
- 4, 4': Schubstange, bewegliche Schiene
- 5: Kugel
- 6: Innenfläche von 2
- 7, 7': Einheit, Magnetwagen
- 8: Rundmagnet
- 9: Zapfen
- 10: Kopplungssteg
- 11: Bohrung
- 12: Aussparung
- 13: separate Fläche
- 14: Anschlag
- 15: Rollen
- 16, 16': Gleitplatte, Außenfläche
- 17: Magnetwagenführung
- 18: Führungsnut
- 19: Sicherungsclip
- 20: Haltering
- 21: Führungsrahmen
- 22: Nut
- 23: Befestigungslöcher
- 24: Öffnung
- 25: Blende
- 26: Zentral körper
- 50, 50', 50": Vorrichtung, Shuttermechanismus, Vorrichtung

- L: Längsachse

## Patentansprüche

1. Vorrichtung (50, 50', 50") für eine gleitreibungsfreie und schmiermittelfreie Bewegung im Vakuum umfassend:
eine positionsfeste Schiene (2'),
eine mittels Magnetkraft bewegliche Schiene (4'),
zumindest zwei, maximal vier, kugelförmige Körper (5), die dazu ausgebildet sind, eine Bewegung der beweglichen Schiene (4') relativ zur positionsfesten Schiene (2') zu ermöglichen, wobei die kugelförmigen Körper (5) zwischen der positionsfesten Schiene (2') und der beweglichen Schiene (4') angeordnet sind, sowie
einer Einheit (7), die dazu ausgebildet ist, die bewegliche Schiene (4') mittels magnetischer Kopplung relativ zur positionsfesten Schiene (2') zu bewegen und nach erfolgreicher Bewegung der beweglichen Schiene (4'), diese ortsfest zu halten.

2. Vorrichtung nach Anspruch 1,
**dadurch gekennzeichnet, dass**
die kugelförmigen Körper (5) dazu ausgebildet sind eine lineare Bewegung der beweglichen Schiene (4') relativ zur positionsfesten Schiene (2') zu ermöglichen.

3. Vorrichtung nach Anspruch 1 oder 2,
**dadurch gekennzeichnet, dass**
die bewegliche Schiene (4) für jeden kugelförmigen Körper (5) eine separate Fläche (13) aufweist, an der der kugelförmige Körper (5) anliegt, insbesondere dass jede separate Fläche (13) zwei Anschläge (14) aufweist.

4. Vorrichtung nach Anspruch 3,
**dadurch gekennzeichnet, dass**
jeder kugelförmige Körper (5) dazu ausgebildet ist linear zwischen den zwei Anschlägen (14) hin- und hergeführt zu werden, und/oder dass eine Weglänge, die die linear verschiebbare bewegliche Schiene (4') zurücklegen kann, durch einen Abstand der zumindest zwei Anschläge (14) gebildet ist, und/oder
dass die Anschläge (14) an der beweglichen Schiene (4') oder an der positionsfesten Schiene (2') vorgesehen sind, und/oder,
dass die bewegliche Schiene (2') zumindest zwei Aussparungen (12) aufweist und, dass jede Aussparung (12) dazu ausgebildet ist, einen kugelförmigen Körper (5) aufzunehmen, wobei bevorzugt zwei Aussparungen (12) auf einer Seite der beweglichen Schiene (4') angeordnet sind, insbesondere, dass jede Aussparung (12) die separate Fläche (13) und die zwei Anschläge (14) aufweist, bevorzugt dass die zwei Anschläge (14) zumindest im Wesentlichen senkrecht zur separaten Fläche (13) angeordnet und die separate Fläche (13) zumindest im Wesentlichen parallel zur positionsfesten Schiene (2') angeordnet ist.

5. Vorrichtung nach zumindest einem der vorstehenden Ansprüche,
**dadurch gekennzeichnet, dass**
die bewegliche Schiene (4') einen Kopplungssteg (10) umfasst, der zur magnetischen Kopplung mit der Einheit (7) ausgebildet ist; und, dass eine Bewegung der beweglichen Schiene (4') relativ zur positionsfesten Schiene (2') durch eine Bewegung des Kopplungsstegs (10) induziert wird.

6. Vorrichtung nach einem der Ansprüche 4 bis 5,
**dadurch gekennzeichnet, dass**
die bewegliche Schiene (4') einen Kopplungssteg (10) umfasst, der zur magnetischen Kopplung mit der Einheit (7) ausgebildet ist; und, dass eine Bewegung der beweglichen Schiene (4') relativ zur positionsfesten Schiene (2') durch eine Bewegung des Kopplungsstegs (10) induziert wird; und
dass der Kopplungssteg (10) zumindest benachbart einer Aussparung (12) vorgesehen ist, insbesondere dass
der Kopplungssteg (10) zwischen den zwei Aussparungen (12) vorgesehen ist.

7. Vorrichtung nach zumindest einem der vorstehenden Ansprüche,
**dadurch gekennzeichnet, dass**
zumindest eine Führungsnut (18) an der beweglichen Schiene (4'), vorzugsweise an der separaten Fläche (13), vorgesehen ist, in der die kugelförmigen Körper (5) geführt werden, um die lineare Bewegung der beweglichen Schiene (4') vorzugeben; und/oder
dass zumindest eine Führungsnut an der positionsfesten Schiene (21) vorgesehen ist, in der die kugelförmigen Körper (5) geführt werden.

8. Vorrichtung nach zumindest einem der vorstehenden Ansprüche,
**dadurch gekennzeichnet, dass**
zwei, vorzugsweise genau zwei, kugelförmige Körper (5) in einer Ebene parallel zur linearen Bewegungsrichtung der beweglichen Schiene (4') angeordnet sind, insbesondere dass, bei Verwendung von vier kugelförmigen Körpern (5), je zwei kugelförmige Körper pro Ebene vorgesehen sind und die zwei Ebenen zumindest im Wesentlichen parallel oder senkrecht zueinander stehen.

9. Vorrichtung nach zumindest einem der vorstehenden Ansprüche,
**dadurch gekennzeichnet, dass**
die Einheit (7) ein magnetisches Material umfasst und zumindest ein Paar an gegensinnig gepolten Magneten (8) aufweist, die die magnetische Kopplung zur beweglichen Schiene (2') bereitstellen; und/oder dass die Einheit (7) ferner zwei Rollen aufweist mittels derer die Einheit (7) relativ zur positionsfesten Schiene (2') verschoben werden kann.

10. Vorrichtung nach zumindest einem der vorstehenden Ansprüche,
**dadurch gekennzeichnet, dass**
die Einheit (7) in einer Führung (17) angeordnet ist, die einen Bewegungsbereich der Einheit (7) vorgibt.

11. Vorrichtung nach zumindest einem der vorstehenden Ansprüche,
**dadurch gekennzeichnet, dass**
die positionsfeste Schiene (2') zwischen der Einheit (7), die dazu ausgebildet ist, die bewegliche Schiene (4') relativ zur positionsfesten Schiene (2') zu bewegen, und der beweglichen Schiene (4') angeordnet ist.

12. Vorrichtung nach zumindest einem der vorstehenden Ansprüche,
**dadurch gekennzeichnet, dass**
die bewegliche Schiene (4') und/oder der Kopplungssteg (10) ein magnetisches Material umfasst, insbesondere dass
das magnetisches Material ein nicht ferromagnetisches Material umfasst.

13. Vorrichtung nach zumindest einem der vorstehenden Ansprüche,
**dadurch gekennzeichnet, dass**
die Einheit (7) Magnete (8) umfasst, die dazu ausgebildet sind, die bewegliche Schiene (4') zu bewegen und ortsfest zu halten, insbesondere dass die Magnete (8) dazu ausgebildet sind, die bewegliche Schiene (4') linear zu bewegen und ortsfest zu halten.

14. Vorrichtung nach zumindest einem der vorstehenden Ansprüche,
**dadurch gekennzeichnet, dass**
die bewegliche Schiene (4') als Schubstange (4) ausgebildet ist, um Objekte, die an der Schubstange (4) angeordnet sind, zu verschieben, insbesondere dass die bewegliche Schiene (4') als Schubstange (4) ausgebildet ist, um Objekte, die an der Schubstange (4) angeordnet sind, linear zu verschieben; und/oder
dass die positionsfeste Schiene (2') durch zumindest eine Kammerwand (2) einer Vakuumkammer (1) gebildet ist, und/oder
dass die positionsfeste Schiene (2') einen runden, quadratischen oder rechteckigen Querschnitt senkrecht zu einer Bewegungsachse der bewegliche Schiene (4') aufweist.

15. Vakuumkammer (1) für eine Beschichtungsanlage mit einer Vorrichtung (50, 50',50") nach zumindest einem der vorstehenden Ansprüche, sowie einer Schubstange (4), bspw. für eine Blende (25), die an der beweglichen Schiene (4') angeordnet ist, wobei die Vorrichtung (50, 50',50") dazu ausgebildet ist, die Schubstange (4), vorzugsweise linear, in der Vakuumkammer (1) zu verfahren.

## Claims

1. An apparatus (50, 50', 50") for sliding friction free and lubricant free movement in vacuum, comprising:
a fixed position rail (2'),
a rail (4') movable by means of magnetic force,
at least two, at most four, spherical-shaped bodies (5) which are configured to enable a movement of the movable rail (4') relative to the fixed position rail (2'), wherein the spherical-shaped bodies (5) are arranged between the fixed position rail (2') and the movable rail (4'), as well as a unit (7) which is configured to move the movable rail (4') by means of magnetic coupling relative to the fixed position rail (2') and to hold the movable rail (4') stationary after a successful movement.

2. An apparatus in accordance with claim 1,
**characterized in that**
the spherical-shaped bodies (5) are configured to enable a linear movement of the movable rail (4') relative to the fixed position rail (2').

3. An apparatus in accordance with claim 1 or claim 2,
**characterized in that**
the movable rail (4) has a separate surface (13) for each spherical-shaped body (5) which separate surface the spherical-shaped body (5) contacts, in particular **in that** each separate surface (13) has two abutments (14).

4. An apparatus in accordance with claim 3,
**characterized in that**
each spherical-shaped body (5) is configured to be guided linearly to and fro between the two abutments (14); and/or
**in that** a path length which the linearly displaceable movable rail (4') can travel is formed by a spacing between the at least two abutments (14); and/or
**in that** the abutments (14) are provided at the movable rail (4') or at the fixed position rail (2'); and/or
**in that** the movable rail (2') has at least two recesses (12), and **in that** each recess (12) is configured to receive one spherical-shaped body (5), with preferably two recesses (12) being arranged at one side of the movable rail (4'), in particular **in that** each recess (12) has the separate surface (13) and the two abutments (14), preferably **in that** the two abutments (14) are arranged at least substantially perpendicular to the separate surface (13) and the separate surface (13) is arranged at least substantially in parallel to the fixed position rail (2').

5. An apparatus in accordance with at least any one of the preceding claims,
**characterized in that**
the movable rail (4') comprises a coupling web (10) which is configured for the magnetic coupling with the unit (7); and **in that** a movement of the movable rail (4') relative to the fixed position rail (2') is induced by a movement of the coupling web (10).

6. An apparatus in accordance with one of the claims 4 to 5,
**characterized in that**
the movable rail (4') comprises a coupling web (10) which is configured for the magnetic coupling with the unit (7); and
**in that** a movement of the movable rail (4') relative to the fixed position rail (2') is induced by a movement of the coupling web (10); and
**in that** the coupling web (10) is provided adjoining at least one recess (12), in particular **in that**
the coupling web (10) is provided between the two recesses (12).

7. An apparatus in accordance with at least any one of the preceding claims,
**characterized in that**
at least one guide groove (18) is provided at the movable rail (4'), preferably at the separate surface (13), in which the spherical-shaped bodies (5) are guided in order to predefine the linear movement of the movable rail (4'); and/or
**in that** at least one guide groove is provided at the fixed position rail (21) in which the spherical-shaped bodies (5) are guided.

8. An apparatus in accordance with at least any one of the preceding claims,
**characterized in that**
two, preferably exactly two, spherical-shaped bodies (5) are arranged in a plane in parallel to the linear movement direction of the movable rail (4'), in particular **in that**, on use of four spherical-shaped bodies (5), two spherical-shaped bodies are provided per plane and the two planes are arranged at least substantially in parallel to one another or perpendicular to one another.

9. An apparatus in accordance with at least any one of the preceding claims,
**characterized in that**
the unit (7) comprises magnetic material and at least a pair of oppositely polarized magnets (8) which make available the magnetic coupling with respect to the movable rail (2'); and/or
**in that** the unit (7) further comprises two rollers by means of which the unit (7) can be displaced relative to the fixed position rail (2').

10. An apparatus in accordance with at least any one of the preceding claims,
**characterized in that** the unit (7) is arranged in a guide (17) which predefines a movement range of the unit (7).

11. An apparatus in accordance with at least any one of the preceding claims,
**characterized in that**
the fixed position rail (2') is arranged between the unit (7) and the movable rail (4'), with the unit (7) being configured to move the movable rail (4') relative to the fixed position rail (2').

12. An apparatus in accordance with at least any one of the preceding claims,
**characterized in that**
the movable rail (4') and/or the coupling web (10) comprises a magnetic material, in particular **in that**
the magnetic material comprises non-ferromagnetic material.

13. An apparatus in accordance with at least any one of the preceding claims,
**characterized in that**
the unit (7) comprises magnets (8) which are configured to move the movable rail (4') and to hold the movable rail stationary, in particular **in that** the magnets (8) are configured to move the movable rail (4') linearly and to hold the moveable rail stationary.

14. An apparatus in accordance with at least any one of the preceding claims,
**characterized in that**
the movable rail (4') is configured as a push rod (4) in order to push objects which are arranged at the push rod (4), in particular **in that** the movable rail (4') is configured as a push rod (4) in order to linearly move objects which are arranged at the push rod (4); and/or
**in that** the fixed position rail (2') is formed by at least one chamber wall (2) of a vacuum chamber (1); and/or
**in that** the fixed position rail (2') has a round, quadratic or rectangular cross-section perpendicular to the movement axis of the movable rail (4').

15. A vacuum chamber (1) for a coating plant having an apparatus (50, 50', 50") in accordance with at least any one of the preceding claims, as well as a push rod (4), for example for an aperture (25) which is arranged at the movable rail (4'), with the apparatus (50, 50', 50") being configured to move, preferably to linearly move, the push rod (4) in the vacuum chamber (1).

## Revendications

1. Dispositif (50, 50', 50") pour un mouvement dans le vide exempt de friction en glissement et exempt de lubrifiant, comprenant :
un rail (2') fixe,
un rail (4') mobile par force magnétique,
au moins deux, au plus quatre, corps sphériques (5) qui sont réalisés pour permettre un mouvement du rail mobile (4') par rapport au rail fixe (2'), les corps sphériques (5) étant disposés entre le rail fixe (2') et le rail mobile (4'), ainsi que
une unité (7) réalisée pour déplacer le rail mobile (4') par rapport au rail fixe (2') au moyen d'un couplage magnétique et, après un déplacement réussi du rail mobile (4'), pour le maintenir stationnaire.

2. Dispositif selon la revendication 1,
**caractérisé en ce que**
les corps sphériques (5) sont réalisés pour permettre un mouvement linéaire du rail mobile (4') par rapport au rail fixe (2').

3. Dispositif selon la revendication 1 ou 2,
**caractérisé en ce que**
le rail mobile (4) comprend, pour chaque corps sphérique (5), une surface séparée (13) contre laquelle s'appuie le corps sphérique (5), en particulier de telle sorte que chaque surface séparée (13) comprend deux butées (14).

4. Dispositif selon la revendication 3,
**caractérisé en ce que**
chaque corps sphérique (5) est réalisé pour être guidé linéairement en va-et-vient entre les deux butées (14), et/ou **en ce que**
une longueur de trajet que le rail mobile (4') déplaçable linéairement peut parcourir est formée par une distance entre lesdites au moins deux butées (14), et/ou **en ce que**
les butées (14) sont prévues sur le rail mobile (4') ou sur le rail fixe (2'), et/ou **en ce que**
le rail mobile (2') présente au moins deux évidements (12), et **en ce que** chaque évidement (12) est réalisé pour recevoir un corps sphérique (5), de préférence deux évidements (12) étant disposés sur un côté du rail mobile (4'), en particulier **en ce que**
chaque évidement (12) comprend ladite surface séparée (13) et lesdites deux butées (14), de préférence **en ce que**
les deux butées (14) sont disposées au moins sensiblement perpendiculaires à la surface séparée (13), et la surface séparée (13) est disposée au moins sensiblement parallèle au rail fixe (2').

5. Dispositif selon l'une au moins des revendications précédentes,
**caractérisé en ce que**
le rail mobile (4') comprend une barrette de couplage (10) réalisée pour être couplée magnétiquement à l'unité (7) ; et **en ce que** un mouvement du rail mobile (4') par rapport au rail fixe (2') est induit par un mouvement de la barrette de couplage (10).

6. Dispositif selon l'une des revendications 4 à 5,
**caractérisé en ce que**
le rail mobile (4') comprend une barrette de couplage (10) réalisée pour être couplée magnétiquement à l'unité (7) ; et **en ce que**
un mouvement du rail mobile (4') par rapport au rail fixe (2') est induit par un mouvement de la barrette de couplage (10) ; et **en ce que**
la barrette de couplage (10) est prévue au moins au voisinage d'un évidement (12), en particulier **en ce que**
la barrette de couplage (10) est prévue entre les deux évidements (12).

7. Dispositif selon l'une au moins des revendications précédentes,
**caractérisé en ce que**
au moins une rainure de guidage (18) est prévue sur le rail mobile (4'), de préférence sur la surface séparée (13), dans laquelle les corps sphériques (5) sont guidés afin de définir le mouvement linéaire du rail mobile (4') ; et/ou **en ce que**
au moins une rainure de guidage est prévue sur le rail fixe (21), dans laquelle les corps sphériques (5) sont guidés.

8. Dispositif selon l'une au moins des revendications précédentes,
**caractérisé en ce que**
deux, de préférence précisément deux, corps sphériques (5) sont disposés dans un plan parallèle à la direction de mouvement linéaire du rail mobile (4'), en particulier **en ce que**
lorsque quatre corps sphériques (5) sont utilisés, deux corps sphériques respectifs sont prévus par plan et les deux plans sont au moins sensiblement parallèles ou perpendiculaires l'un à l'autre.

9. Dispositif selon l'une au moins des revendications précédentes,
**caractérisé en ce que**
l'unité (7) comprend un matériau magnétique et présente au moins une paire d'aimants à pôles opposés (8) assurant le couplage magnétique au rail mobile (2') ; et/ou **en ce que**
l'unité (7) comprend en outre deux galets au moyen desquels l'unité (7) peut être déplacée par rapport au rail fixe (2').

10. Dispositif selon l'une au moins des revendications précédentes,
**caractérisé en ce que**
l'unité (7) est disposée dans un guide (17) qui définit une plage de mouvement de l'unité (7).

11. Dispositif selon l'une au moins des revendications précédentes,
**caractérisé en ce que**
le rail fixe (2') est disposé entre l'unité (7), réalisée pour déplacer le rail mobile (4') par rapport au rail fixe (2'), et le rail mobile (4').

12. Dispositif selon l'une au moins des revendications précédentes,
**caractérisé en ce que**
le rail mobile (4') et/ou la barrette de couplage (10) comprend un matériau magnétique, en particulier **en ce que**
le matériau magnétique comprend un matériau non ferromagnétique.

13. Dispositif selon l'une au moins des revendications précédentes,
**caractérisé en ce que**
l'unité (7) comprend des aimants (8) réalisés pour déplacer et maintenir stationnaire le rail mobile (4'), en particulier **en ce que**
les aimants (8) sont réalisés pour déplacer linéairement le rail mobile (4') et pour le maintenir stationnaire.

14. Dispositif selon l'une au moins des revendications précédentes,
**caractérisé en ce que**
le rail mobile (4') est réalisé sous forme de tige de poussée (4) pour déplacer des objets disposés sur la tige de poussée (4), en particulier **en ce que** le rail mobile (4') est réalisé sous forme de tige de poussée (4) pour déplacer linéairement des objets disposés sur la tige de poussée (4) ; et/ou **en ce que**
le rail fixe (2') est formé par au moins une paroi de chambre (2) d'une chambre à vide (1), et/ou **en ce que**
le rail fixe (2') présente une section transversale ronde, carrée ou rectangulaire perpendiculaire à un axe de mouvement du rail mobile (4').

15. Chambre à vide (1) destinée à une installation de revêtement comprenant un dispositif (50, 50', 50") selon l'une au moins des revendications précédentes, et une tige de poussée (4), par exemple destinée à un diaphragme (25) disposé sur le rail mobile (4'), le dispositif (50, 50', 50") étant réalisé pour déplacer la tige de poussée (4), de préférence linéairement, dans la chambre à vide (1).
